# EUROPÄISCHE PATENTSCHRIFT

(11) **EP 2 823 321 B1**
(45) Veröffentlichungstag und Bekanntmachung des Hinweises auf die Patenterteilung: **21.10.2015**
(21) Anmeldenummer: 13700697.9
(22) Anmeldetag: 15.01.2013
(51) Int. Cl.: G01R 31/36, G01R 1/20

(54) **ELEKTRONISCHER BATTERIESENSOR**
ELECTRONIC BATTERY SENSOR
CAPTEUR DE BATTERIE ÉLECTRONIQUE

(30) Priorität: 05.03.2012 DE 102012203446
(43) Veröffentlichungstag der Anmeldung: 14.01.2015
(73) Patentinhaber: Robert Bosch GmbH, 70442 Stuttgart (DE)
(72) Erfinder: DOLLANSKY, Matthias, 71701 Schwieberdingen (DE); SCHIMMEL, Chris, 71332 Waiblingen (DE); MUELLER, Michael, 71277 Rutesheim (DE)
(86) Internationale Anmeldenummer: PCT/EP2013/050636
(87) Internationale Veröffentlichungsnummer: WO 2013/131665

(56) Entgegenhaltungen:
- DE-A1-102004 053 648
- DE-A1-102004 053 650
- DE-A1-102004 055 849
- DE-U1-202007 006 287
- US-A1- 2005 057 865
- US-A1- 2007 177 318
- US-A1- 2008 050 985
- US-A1- 2011 062 945

## Beschreibung

Die vorliegende Erfindung betrifft einen elektronischen Batteriesensor sowie einen Shuntwiderstand zum Einsatz in einem elektronischen Batteriesensor. Ferner wird ein entsprechendes Verfahren zur Bereitstellung eines elektronischen Batteriesensors bereitgestellt.

### Stand der Technik

Insbesondere im Winter zählen Ausfälle durch entladene oder vorzeitig gealterte Batterien nach wie vor zu den häufigsten Fehlerursachen. Eine immer größer werdende Anzahl von elektronischen Funktionen in einem Kraftfahrzeug, wie bspw. Sitz- und Standheizung oder DVD-Player, und deren gleichzeitiger Betrieb erfordern ein gut entwickeltes Batterie- bzw. Energiemanagement. Ein wichtiger Teil eines derartigen Batteriemanagements ist ein elektronischer Batteriesensor, der in regelmäßigen Abständen Spannung, Stromstärke und Temperatur in der Nähe einer entsprechenden Kraftfahrzeugbatterie genau erfasst. Dabei werden die Daten, anders wie bei anderen Sensoren, nicht an ein Steuergerät weitergegeben, sondern von einem in dem Batteriesensor integrierten Steuergerät verarbeitet. Dadurch können ein Zustand einer Batterie erkannt und Fragen, bspw. "Wie wird die Restladung z. B. am nächsten Morgen sein?", "Wie wird die Spannung am nächsten Morgen sein?" oder "Wie haben sich Kapazität und Leistung im Laufe der Zeit entwickelt?" beantwortet werden. Entsprechende Auswertungen werden als Signal an ein Bordnetz des jeweiligen Kraftfahrzeugs weitergegeben, so dass von einem dort ansässigen Bordnetzsteuergerät weitere Aktionen, wie bspw. Abschalten des Motors bei Stillstand an der Ampel, durchgeführt werden können.

Mit Hilfe eines elektronischen Batteriesensors werden demnach Spannungen und Strom (über einen Shuntwiderstand) und Temperaturen in der Regel permanent gemessen und gespeichert, d. h. auch in Ruhephasen der jeweiligen Batterie. Damit ist nicht nur eine Restladung der Batterie bekannt, sondern aus Erfahrungswerten vergangener Motorstarts auch eine Anforderung an einen Energiespeicher. Auch können derzeitige und frühere Werte verglichen werden, so dass Erkenntnisse über eine Alterung und mögliche Restlebensdauer einer Batterie möglich sind. Durch das Vorsehen eines Batteriesensors ist es möglich, dass das den Batteriesensor umfassende Energiemanagementsystem in kritischen Zonen rechtzeitig vorsieht, nicht unbedingt nötige Funktionen, wie bspw. eine zweite Stufe einer Heckscheibenheizung oder einer Frontscheibe bereits abzuschalten, wenn sich die Batterie einem kritischen Zustand auch nur nähert.

DE 10 200 4 053 648 A1, DE 10 2004 053 650 A1, DE 10 2004 055 849 A1, US 2011/062945 A1, US 2007/177318 A1, US 2005/057865 A1, US 2008/050985 A1, DE 20 2007 006 287 U1 offenbaren verschiedene Batteriesensoren.

Da der Batteriesensor an einer Batterie anzuordnen ist und dort wünschenswerterweise möglichst platzsparend und unauffällig platziert werden sollte, war es nunmehr eine Aufgabe der vorliegenden Erfindung, einen elektronischen Batteriesensor vorzusehen, der einfach aufgebaut und platzsparend in einer Polnische einer Kraftfahrzeugbatterie möglichst vollständig integriert werden kann.

### Offenbarung der Erfindung

Vor dem Hintergrund des Standes der Technik und der voranstehend genannten Aufgabe stellt die Erfindung nunmehr einen elektronischen Batteriesensor mit den Merkmalen von Patentanspruch 1, einen Shuntwiderstand mit den Merkmalen von Patentanspruch 6 sowie ein Verfahren zur Bereitstellung eines elektronischen Batteriesensors mit den Merkmalen von Patentanspruch 8 bereit.

Erfindungsgemäß wird ein elektronischer Batteriesensor zur Zustandserkennung einer Batterie bereitgestellt. Der erfindungsgemäß vorgestellte elektronische Batteriesensor umfasst einen Shuntwiderstand und eine Leiterplatte mit einer Messschaltung, wobei der Shuntwiderstand eine Ausnehmung und darin angeordnete Zentrierschenkel aufweist und die Leiterplatte in die Ausnehmung eingepasst, durch die Zentrierschenkel ausgerichtet und mit den Zentrierschenkeln verlötet ist.

Bei der Leiterplatte handelt es sich vorzugsweise um eine Flex-Leiterplatte. Dabei handelt es sich um eine in der Regel aus einer Polyesterfolie hergestellte flexible Leiterplatte, welche raum- und gewichtsminimierend eingebaut werden kann. Als Basismaterial für flexible Leiterplatten sind Polyimidfolien denkbar, welche eine hohe Temperaturbelastbarkeit und eine uneingeschränkte Lötbarkeit sowie einen ausreichend großen Betriebstemperaturbereich aufweisen.

Eine flexible Leiterplatte ist, wie der Name schon sagt, biegsam und somit an eine Form, wie bspw. eine Batterienische beim Einbau des Batteriesensors anpassbar.

Gemäß einer weiteren Ausführungsform des elektronischen Batteriesensors stellt der Shuntwiderstand eine Messbrücke aus Kupfer/Manganin/Kupfer dar und weist zudem zwei Anschlüsse auf. An einem der Anschlüsse ist in der Regel eine Polklemme einer zu überwachenden Batterie anzuschließen, während an dem anderen Anschluss ein entsprechend vorgesehener Kabelschuh anzuschließen ist. Der elektronische Batteriesensor ist in der Regel in eine Batterienische eines Minuspols einer zu kontrollierenden Batterie einzubauen. Durch einen einfach gehaltenen Shuntwiderstand, wie erfindungsgemäß vorgesehen, besteht die Möglichkeit, die zwei vorgesehenen Anschlüsse relativ frei zu wählen und somit eine Kontaktierung der besagten Polklemme oder des besagten Kabelschuhs zu vereinfachen. Beide Anschlüsse können gleich ausgeführt sein. Dabei können sie bspw. als Durchgangslöcher ausgebildet sein, durch welche jeweilig eine Schraube durchzuführen ist, auf welcher ein Kabelschuh oder eine Polklemme aufgesetzt und letztlich mit einer Mutter verschraubt wird. Alternativ dazu können beide Anschlüsse jeweilig durch einen an dem Shuntwiderstand fest angeordneten Gewindebolzen realisiert sein, auf welchem wiederum ein Kabelschuh oder eine Polklemme aufzusetzen und mit einer Mutter zu verschrauben ist. Es ist auch denkbar, dass ein Anschluss als Durchgangsloch und der andere als Gewindebolzen ausgeführt ist.

Gemäß einer weiteren Ausführungsform des erfindungsgemäßen elektronischen Batteriesensors sind die Zentrierschenkel aus Kupfer und in einem Reflow-Verfahren mit der Leiterplatte verlötet.

In einer weiteren Ausführungsform des erfindungsgemäßen elektronischen Batteriesensors ist die Flex-Leiterplatte in Anpassung an eine Batterienische, in welcher der Batteriesensor anzuordnen ist, gegenüber dem Shuntwiderstand abgewinkelt.

Ferner schlägt die vorliegende Erfindung einen Shuntwiderstand mit zwei Anschlüssen, einer Ausnehmung und darin angeordneten Zentrierschenkeln vor, wobei eine Leiterplatte in die Ausnehmung einzupassen, durch die Zentrierschenkel auszurichten und mit den Zentrierschenkeln zu verlöten ist.

Ein derartiger Shuntwiderstand kann generell bei Steuergeräten, Sensoren oder sonstigen elektronischen Geräten mit Shunt-Schnittstellen eingesetzt werden. Der erfindungsgemäß vorgesehene Shunt kann eine Messbrücke aus Kupfer/Manganin/Kupfer vorsehen, wobei die vorgesehenen Zentrierschenkel in der Regel aus Kupfer sind und in einem Reflow-Verfahren mit einer darin einzupassenden Leiterplatte zu verlöten sind.

Insbesondere bezieht sich die vorliegende Erfindung auf einen Shuntwiderstand, wie er in einem erfindungsgemäßen elektronischen Batteriesensor vorzusehen ist.

Ferner beschreibt die vorliegende Erfindung ein Verfahren zur Bereitstellung eines elektronischen Batteriesensors zur Zustandserkennung einer Batterie. Bei dem erfindungsgemäßen Verfahren werden ein Shuntwiderstand mit zwei Anschlüssen, einer Ausnehmung und darin angeordneten Zentrierschenkeln und eine Leiterplatte mit einer Messschaltung bereitgestellt. Ferner wird die Leiterplatte in die Ausnehmung eingepasst, durch die Zentrierschenkel ausgerichtet und mit den Zentrierschenkeln verlötet.

Vorzugsweise wird als Leiterplatte eine Flex-Leiterplatte ausgewählt und der Shuntwiderstand wird als eine Messbrücke aus Kupfer/Manganin/Kupfer gefertigt.

Ferner ist es möglich, dass die Zentrierschenkel aus Kupfer gefertigt und in einem Reflow-Verfahren mit der Leiterplatte verlötet werden. Unter einem Reflow-Verfahren versteht man ein Weichlötverfahren zum Löten von sogenannten SMD-Bauelementen (SMD: surface mounted device). Beim Reflow-Verfahren wird das Material in Form von Lötpaste vor einer Bestückung auf eine entsprechende Leiterplatte aufgetragen, in einem nächsten Schritt die Bauteile bestückt, wobei eine Verwendung von Lötpaste den Vorteil hat, dass diese klebrig ist und so die Bauteile bei der Bestückung direkt an der Paste halten. Beim darauffolgenden Aufschmelzen des verbleibenden Lotes zentrieren sich die bestückten Bauteile durch die Oberflächenspannung auf entsprechenden Landepads und setzen sich ab. Gemäß einem derartigen Reflow-Verfahren bzw. Reflow-Löten wird erfindungsgemäß die Leiterplatte mit den Zentrierschenkeln verlötet.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnungen

- Figur 1: zeigt in schematischer Darstellung eine Schnittansicht einer Ausführungsform eines erfindungsgemäßen elektronischen Batteriesensors.
- Figur 2: zeigt in Figur 2a eine Ausführungsform eines erfindungsgemäßen Shuntwiderstands, der, wie in Figur 2b gezeigt, mit einer Leiterplatte kombiniert eine weitere Ausführungsform eines erfindungsgemäßen elektronischen Batteriesensors bildet.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

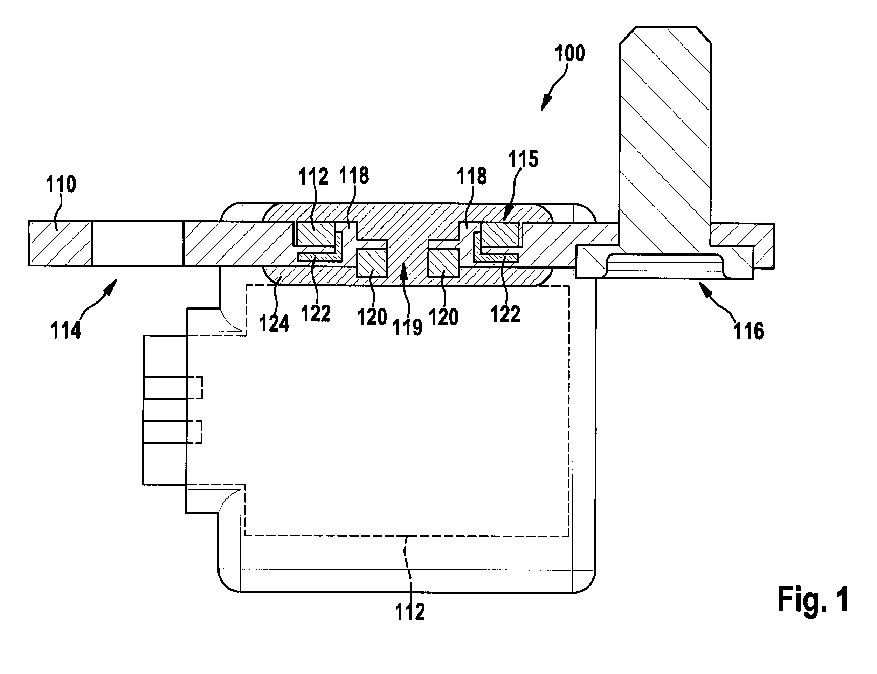

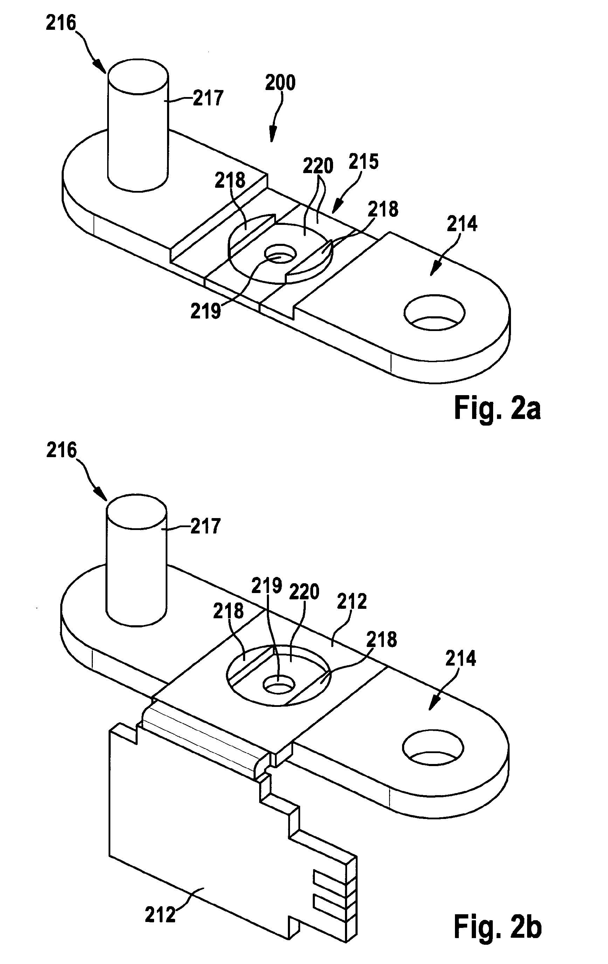

Figur 1 zeigt in schematischer Darstellung eine Schnittansicht einer Ausführungsform eines erfindungsgemäßen elektronischen Batteriesensors 100. Der Batteriesensors 100 umfasst einen Shuntwiderstand 110 und eine Leiterplatte 112. Der Shuntwiderstand 110 ist als Messbrücke aus Kupfer/Manganin/Kupfer ausgebildet. Dies wird noch näher in Figur 2 erläutert. Der Shuntwiderstand 110 umfasst zwei Anschlüsse, einen Anschluss 114 und einen weiteren Anschluss 116. Anschluss 114 ist in der hier dargestellten Form als Durchbruch bzw. Durchgangsloch ausgebildet, durch welches eine Schraube durchgeführt, darauf ein Kabelschuh aufgesetzt und dann eine Mutter aufgeschraubt werden kann, so dass in Sandwich-Form ein Kontakt hergestellt wird. Anschluss 116 ist als Durchgangsloch mit einem darin fest eingepassten Gewindebolzen ausgebildet, wobei der Gewindebolzen durch eine Polklemme einer zu überwachenden Batterie durchgeführt werden kann und dann mittels einer Mutter verschraubt werden kann. Der Gewindebolzen ist in den Shuntwiderstand 110 fest eingefügt, d. h. eingeklemmt und/oder verklebt. Der Shuntwiderstand 110 hat in seinem zentralen Bereich eine Ausnehmung 115. In der Ausnehmung 115 sind Zentrierschenkel 118 vorgesehen, welche auf ihrer von der Ausnehmung 115 wegweisenden Oberkante mit der Oberkante des Shuntwiderstands 110 wiederum abschließen. In der hier dargestellten Ausführungsform ist in der Mitte der Ausnehmung 115 wiederum ein Durchgangsloch 119 vorgesehen, welches bei einem späteren Molding-Verfahren ermöglicht, dass eine dabei zu verwendende Mold-Masse zum besseren Einschluss des Batteriesensors innerhalb einer Molding-Ummantelung hindurch fließen kann. Der Shuntwiderstand 110 besteht, wie voranstehend bereits erwähnt, in Folge aus Kupfer/Manganin/Kupfer, wobei die Manganinbereiche hier mit dem Bezugszeichen 120 gekennzeichnet sind.

Die Leiterplatte 112 wird nunmehr in die Ausnehmung eingepasst und mit den Zentrierschenkeln 118 verlötet. Dieses Verlöten kann in einem sogenannten Reflow-Verfahren vorgenommen werden. Der Lötbereich 122 kann sich über die Seitenkanten der Zentrierschenkel 118 und in einen Bereich einer Grundfläche der Ausnehmung 115 erstrecken. Der Lötbereich 122 ist hier durch einen dunklen rechten Winkel angedeutet. Die Leiterplatte 112 kann als Flex-Leiterplatte ausgebildet sein und demnach relativ zu dem Shuntwiderstand 110 abgewinkelt werden, so dass der Shuntwiderstand 110 und die Leiterplatte 112 zusammen eine Art rechten Winkel bilden, so dass der dadurch dargestellte elektronische Batteriesensor sehr raumsparend in eine Batterienische einer zu kontrollierenden Batterie eingesetzt werden kann. Nach Verlöten der Leiterplatte 112 mit dem Shuntwiderstand 110 im Lötbereich 122 und nach Ausrichtung der Leiterplatte 112 zwecks Einbau in eine dafür vorgesehene Batterienische wird die aus Shuntwiderstand 110 und Leiterplatte 112 bestehende Baugruppe in einem Mold-Verfahren ummolded bzw. ummantelt. Diese Ummantelung wird mit Bezugszeichen 124 angedeutet.

Figur 2a zeigt einen Shuntwiderstand, wie er in einer Ausführungsform eines erfindungsgemäßen elektronischen Batteriesensors eingesetzt werden kann. Ferner stellt dieser Shuntwiderstand auch eine Ausführungsform eines erfindungsgemäßen Shuntwiderstands dar, wie er auch bei Steuergeräten, Sensoren oder sonstigen elektronischen Geräten mit Shunt-Schnittstellen eingesetzt werden kann. Der Shuntwiderstand 200 weist zwei Anschlüsse 214 und 216 auf. Anschluss 216 ist als Durchgangsloch mit einem darin fest eingesetzten Gewindebolzen 217 ausgebildet. Anschluss 214 ist als Durchgangsloch dargestellt. Der Gewindebolzen 217 von Anschluss 216 kann durch eine Polklemme einer zu kontrollierenden Batterie durchgeführt und dann durch eine Mutter, welche auf den Gewindebolzen aufzuschrauben ist, fest mit der Polklemme verschraubt werden. Durch Anschluss 214 kann eine Schraube durchgeführt, dann ein Kabelschuh auf die Schraube aufgesetzt und der Kabelschuh mit Anschluss 214 durch weiteres Aufsetzen einer Mutter auf die Schraube verschraubt und damit kontaktiert werden. Die Kontaktierung von Anschluss 216 und 214 erfolgt jeweils durch eine Art Sandwich-Struktur. Der Shuntwiderstand 200 weist des weiteren eine Ausnehmung 215 auf. Innerhalb der Ausnehmung ist ein Bereich der Grundfläche der Ausnehmung 215 aus Manganin 220. Ferner befinden sich in der Ausnehmung 215 Zentrierschenkel, hier zwei Zentrierschenkel, welche in der Regel aus Kupfer gefertigt sind und von der Grundfläche der Ausnehmung senkrecht nach oben stehen und mit der Oberkante des Shuntwiderstands 200 außerhalb der Ausnehmung 215 abschließen. In der hier dargestellten Ausführungsform des Shuntwiderstands 200 sind die Zentrierschenkel 218 halbkreisförmig ausgebildet. Zentral in der Ausnehmung 215 befindet sich des weiteren ein Durchgangsloch 219, welches dazu vorgesehen ist, dass bei einem späteren durchzuführenden Molding-Prozess eine dabei zu verwendende Mold-Masse durch diese Durchgangsöffnung 219 durchdringen kann und somit den Shuntwiderstand 200 fest in der Moldmasse einschließen kann.

Figur 2b zeigt den Shuntwiderstand 200 aus Figur 2a mit einer in die Ausnehmung 215 eingepassten und mit den Zentrierschenkeln 218 verlöteten Leiterplatte 212. Die Leiterplatte 212 ist in der hier gezeigten Form exakt in die Ausnehmung eingepasst und mit den Zentrierschenkeln 218 verlötet. Die Oberfläche der Leiterplatte 212 schließt bündig mit der Oberfläche des Shuntwiderstands 200 außerhalb der Ausnehmung 215 ab, so dass hier eine insgesamt glatte Oberfläche entsteht. Die Leiterplatte 212 ist hier als Flex-Leiterplatte ausgebildet, so dass es möglich ist, wie hier dargestellt, dass die Leiterplatte 212 gegenüber dem Shuntwiderstand 200 abgeknickt wird, was wiederum ermöglicht, die Kombination aus Shuntwiderstand und Leiterplatte möglichst raumsparend in eine Batterienische einer zu kontrollierenden Batterie einzusetzen.

Manganin ist eine Kupfer-Mangan-Legierung, eine sogenannte Widerstandslegierung, mit einem mittleren spezifischen elektrischen Widerstand und einem geringen linearen Temperaturkoeffizienten. Aufgrund der geringen Temperaturabhängigkeit ist Manganin gut als Messmaterial zu verwenden.

## Patentansprüche

1. Elektronischer Batteriesensor (100) zur Zustandserkennung einer Batterie mit einem Shuntwiderstand (110) und einer Leiterplatte (112) mit einer Messschaltung, wobei der Shuntwiderstand (110) eine Ausnehmung (115) und darin angeordnete Zentrierschenkel (118) aufweist und die Leiterplatte (112) in die Ausnehmung (115) eingepasst, durch die Zentrierschenkel (118) ausgerichtet und mit den Zentrierschenkeln (118) verlötet ist und wobei sowohl in der Leiterplatte (112) als auch in der Ausnehmung (115) des Shuntwiderstands (110) jeweils ein Durchgangsloch (119, 219) angeordnet ist, das bei einem später durchzuführenden Molding-Verfahren ermöglicht, dass eine bei dem Molding-Verfahren zu verwendende Mold-Masse zum Einschluss des Shuntwiderstands (110) innerhalb einer Molding-Ummantelung durch den Batteriesensor (100) hindurch fließen kann und wobei der Shuntwiderstand (110) mittels der Zentrierschenkel (118) als Messbrücke ausgestaltet ist.

2. Elektronischer Batteriesensor nach Anspruch 1, bei dem die Leiterplatte (112) eine Flex-Leiterplatte ist.

3. Elektronischer Batteriesensor nach Anspruch 1 oder 2, bei dem der Shuntwiderstand (110) eine Messbrücke aus Kupfer/Manganin/Kupfer darstellt und zwei Anschlüsse (114, 116) aufweist.

4. Elektronischer Batteriesensor nach einem der voranstehenden Ansprüche, bei dem die Zentrierschenkel (118) aus Kupfer sind und in einem Reflow-Verfahren mit der Leiterplatte (112) verlötet sind.

5. Elektronischer Batteriesensor nach einem der Ansprüche 2 bis 4, bei dem die Flex-Leiterplatte (112) in Anpassung an eine Batterienische, in welcher der Batteriesensor anzuordnen ist, gegenüber dem Shuntwiderstand (110) abgewinkelt ist.

6. Shuntwiderstand mit zwei Anschlüssen (114, 116, 214, 216)und einer Ausnehmung (115, 215) und darin angeordneten Zentrierschenkeln (118, 218), wobei eine Leiterplatte (112, 212) in die Ausnehmung (115, 215) einzupassen, durch die Zentrierschenkel (118, 218) auszurichten und mit den Zentrierschenkeln (118, 218) zu verlöten ist und wobei sowohl in der Leiterplatte (112) als auch in der Ausnehmung (115) des Shuntwiderstands (110) jeweils ein Durchgangsloch (119, 219) angeordnet ist, das bei einem später durchzuführenden Molding-Verfahren ermöglicht, dass eine bei dem Molding-Verfahren zu verwendende Mold-Masse zum Einschluss des Shuntwiderstands (110) innerhalb einer Molding-Ummantelung durch den Batteriesensor (100) hindurch fließen kann und wobei der Shuntwiderstand (110) mittels der Zentrierschenkel (118) als Messbrücke ausgestaltet ist.

7. Shuntwiderstand, der in einem elektronischen Batteriesensor nach einem der Ansprüche 1 bis 5 vorzusehen ist.

8. Verfahren zur Bereitstellung eines elektronischen Batteriesensors zur Zustandserkennung einer Batterie, bei dem ein Shuntwiderstand mit zwei Anschlüssen, einer Ausnehmung und darin angeordneten Zentrierschenkeln, und eine Leiterplatte mit einer Messschaltung bereitgestellt werden, und die Leiterplatte in die Ausnehmung eingepasst, durch die Zentrierschenkel ausgerichtet und mit den Zentrierschenkeln in einem Reflow Verfahren verlötet wird, und bei dem eine Mold-Masse später während eines Mold-Verfahrens durch ein sowohl in der Leiterplatte als auch in der Ausnehmung des Shuntwiderstands angeordnetes Durchgangsloch geleitet wird, um den Shuntwiderstand in einer Mold-Ummantelung einzuschließen, und bei dem die Zentrierschenkel derart ausgebildet werden, dass der Shuntwiderstand in Verbindung mit den Zentrierschenkeln als Messbrücke zu verwenden ist.

9. Verfahren nach Anspruch 8, bei dem als Leiterplatte eine Flex-Leiterplatte ausgewählt wird und der Shuntwiderstand als eine Messbrücke aus Kupfer/Manganin/Kupfer gefertigt wird.

10. Verfahren nach Anspruch 8, bei dem die Zentrierschenkel aus Kupfer gefertigt und in einem Reflow-Verfahren mit der Leiterplatte verlötet werden.

## Claims

1. Electronic battery sensor (100) for identifying the state of a battery, having a shunt resistor (110) and a printed circuit (112) with a measurement circuit, wherein the shunt resistor (110) has a recess (115) and centring limbs (118) which are arranged in the said recess, and the printed circuit (112) fits into the recess (115), is oriented by the centring limbs (118) and is soldered to the centring limbs (118), and wherein a respective passage hole (119, 219) is arranged both in the printed circuit (112) and in the recess (115) in the shunt resistor (110), the said passage hole, during a moulding process which is to be carried out later, allowing a moulding compound which is to be used during the moulding process for incorporating the shunt resistor (110) within a moulding casing to flow through the battery sensor (100), and wherein the shunt resistor (110) is designed as a measurement bridge by means of the centring limbs (118).

2. Electronic battery sensor according to Claim 1, in which the printed circuit (112) is a flexible printed circuit.

3. Electronic battery sensor according to Claim 1 or 2, in which the shunt resistor (110) constitutes a measurement bridge which is composed of copper/Manganin/copper and has two connections (114, 116).

4. Electronic battery sensor according to one of the preceding claims, in which the centring limbs (118) are composed of copper and are soldered to the printed circuit (112) in a reflow process.

5. Electronic battery sensor according to one of Claims 2 to 4, in which the flexible printed circuit (112) is angled in relation to the shunt resistor (110) so as to adapt to a battery niche in which the battery sensor is to be arranged.

6. Shunt resistor having two connections (114, 116, 214, 216) and a recess (115, 215) and centring limbs (118, 218) which are arranged in the said recess, wherein a printed circuit (112, 212) is to be fitted into the recess (115, 215), oriented by the centring limbs (118, 218) and soldered to the centring limbs (118, 218), and wherein a respective passage hole (119, 219) is arranged both in the printed circuit (112) and in the recess (115) in the shunt resistor (110), the said passage hole, during a moulding process which is to be carried out later, allowing a moulding compound which is to be used during the moulding process for incorporating the shunt resistor (110) within a moulding casing to flow through the battery sensor (100), and wherein the shunt resistor (110) is designed as a measurement bridge by means of the centring limbs (118).

7. Shunt resistor which is to be provided in an electronic battery sensor according to one of Claims 1 to 5.

8. Method for providing an electronic battery sensor for identifying the state of a battery, in which method a shunt resistor having two connections, a recess and centring limbs which are arranged in the said recess, and a printed circuit having a measurement circuit are provided, and the printed circuit fits into the recess, is oriented by the centring limbs and is soldered to the centring limbs in a reflow process, and in which method a moulding compound, later during a moulding process, is conducted through a passage hole which is arranged both in the printed circuit and in the recess in the shunt resistor in order to incorporate the shunt resistor in a moulding casing, and in which method the centring limbs are formed in such a way that the shunt resistor, in conjunction with the centring limbs, is to be used as a measurement bridge.

9. Method according to Claim 8, in which a flexible printed circuit is chosen as the printed circuit, and the shunt resistor is produced as a measurement bridge which is composed of copper/Manganin/copper.

10. Method according to Claim 8, in which the centring limbs are produced from copper and are soldered to the printed circuit in a reflow process.

## Revendications

1. Capteur électronique de batterie (100) destiné à détecter l'état d'une batterie,
le capteur présentant une résistance de shunt (110) et une carte de circuit (112) dotée d'un circuit de mesure,
la résistance de shunt (110) présentant une découpe (115) dans laquelle sont disposées des plaques de centrage (118) et la carte de circuit (112) étant insérée dans la découpe (115), alignée par les plaques de centrage (118) et brasée sur les plaques de centrage (118),
un trou de passage (119, 219) étant disposé à la fois dans la carte de circuit (112) et dans la découpe (115) de la résistance de shunt (110) et permettant lors d'une opération de moulage exécutée ultérieurement que la pâte de moulage utilisée lors de l'opération de moulage puisse s'écouler à travers le capteur de batterie (100) en incluant la résistance de shunt (110) à l'intérieur d'une enveloppe moulée et la résistance de shunt (110) étant configurée comme pont de mesure au moyen des plaques de centrage (118).

2. Capteur électronique de batterie selon la revendication 1, dans lequel la carte de circuit (112) est une carte de circuit flexible.

3. Capteur électronique de batterie selon les revendications 1 ou 2, dans lequel la résistance de shunt (110) est un pont de mesure en cuivre/manganine/cuivre et présente deux bornes de raccordement (114, 116).

4. Capteur électronique de batterie selon l'une des revendications précédentes, dans lequel les plaques de centrage (118) sont en cuivre et sont brasées sur la carte de circuit (112) dans une opération de brasage à la nappe.

5. Capteur électronique de batterie selon l'une des revendications 2 à 4, dans lequel la carte de circuit flexible (112) est coudée par rapport à la résistance de shunt (110) pour s'adapter à une niche de batterie dans laquelle le capteur de batterie doit être placé.

6. Résistance de shunt dotée de deux bornes de raccordement (114, 116, 214, 216) et d'une découpe (115, 215) dans laquelle sont disposées des plaques de centrage (118, 218), une carte de circuit (112, 212) devant être insérée dans la découpe (115, 215), alignée par les plaques de centrage (118, 218) et brasée sur les plaques de centrage (118, 218), un trou de passage (119, 219) étant disposé à la fois dans la carte de circuit (112) et dans la découpe (115) de la résistance de shunt (110) et permettant lors d'une opération de moulage réalisée ultérieurement à une pâte de moulage utilisée dans l'opération de moulage de pouvoir s'écouler à travers le capteur de batterie (100) pour englober la résistance de shunt (110) à l'intérieur d'une enveloppe moulée, la résistance de shunt (110) étant configurée comme pont de mesure au moyen des plaques de centrage (118).

7. Résistance de shunt prévue dans un capteur électronique de batterie selon l'une des revendications 1 à 5.

8. Procédé de réalisation d'un capteur électronique de batterie permettant de détecter l'état d'une batterie, dans lequel une carte de circuit et une résistance de shunt dotée de deux bornes de raccordement et d'une découpe dans laquelle sont disposées des plaques de centrage sont réalisées, la carte de circuit étant insérée dans la découpe, alignée par les plaques de centrage et brasée sur les plaques de centrage par une opération de brasage à la nappe, un trou de passage étant formé à la fois dans la carte de circuit et dans la découpe de la résistance de shunt et permettant lors d'une opération de moulage réalisée ultérieurement à une pâte de moulage utilisée dans l'opération de moulage de pouvoir s'écouler à travers le capteur de batterie pour englober la résistance de shunt à l'intérieur d'une enveloppe moulée, les plaques de centrage étant configurées de telle sorte que la résistance de shunt soit utilisée en association avec les plaques de centrage comme pont de mesure.

9. Procédé selon la revendication 8, dans lequel une carte de circuit flexible est sélectionnée comme carte de circuit et la résistance de shunt est réalisée sous la forme d'un pont de mesure en cuivre/manganine/cuivre.

10. Procédé selon la revendication 8, dans lequel les plaques de centrage sont réalisées en cuivre et sont brasées sur la carte de circuit au moyen d'une opération de brasage à la nappe.
